(19) Europäisches Patentamt
European Patent Office
Office européen des brevets

(11) **EP 1 723 681 B1**

(12) # EUROPÄISCHE PATENTSCHRIFT

(45) Veröffentlichungstag und Bekanntmachung des Hinweises auf die Patenterteilung:
**05.10.2016 Patentblatt 2016/40**

(51) Int Cl.:
***H01L 31/0224*** (2006.01)

(21) Anmeldenummer: **05728338.4**

(22) Anmeldetag: **08.03.2005**

(86) Internationale Anmeldenummer:
**PCT/EP2005/002414**

(87) Internationale Veröffentlichungsnummer:
**WO 2005/088730 (22.09.2005 Gazette 2005/38)**

(54) **VERFAHREN ZUM AUSBILDEN EINER STRUKTUR**

METHOD FOR FORMING A STRUCTURE

PROCÉDÉ POUR FORMER UNE STRUCTURE

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **09.03.2004 EP 04005540**

(43) Veröffentlichungstag der Anmeldung:
**22.11.2006 Patentblatt 2006/47**

(73) Patentinhaber: **Fraunhofer Gesellschaft zur Förderung der angewandten Forschung e.V.
80686 München (DE)**

(72) Erfinder:
• **SCHWIRTLICH, Ingo
63987 Miltenberg (DE)**
• **VON CAMPE, Hilmar
61352 Bad Homburg (DE)**

(56) Entgegenhaltungen:
EP-A- 0 784 326     EP-A- 1 119 007
WO-A-93/24934       US-A- 4 457 861
US-B1- 6 312 864    US-B1- 6 322 620

• **LENKEIT B ET AL COMMISSION OF THE EUROPEAN COMMUNITIES: "HIGH QUALITY SCREEN-PRINTED AND FIRED-THROUGH SILICON NITRIDE REAR CONTACTS FOR BIFACIAL SILICON SOLAR CELLS" 16TH. E.C. PHOTOVOLTAIC SOLAR ENERGY CONFERENCE. GLASCOW, UNITED KINGDOM, MAY 1 - 5, 2000, PROCEEDINGS OF THE INTERNATIONAL PHOTOVOLTAIC SOLAR ENERGY CONFERENCE, LONDON : JAMES & JAMES LTD, GB, Bd. VOL. 2 OF 3. CONF. 16, 1. Mai 2000 (2000-05-01), Seiten 1332-1335, XP001138888 ISBN: 1-902916-18-2 in der Anmeldung erwähnt**
• **HORZEL J SIVOTHTHAMAN S ET AL COMMISSION OF THE EUROPEAN COMMUNITIES: "SCREEN-PRINTED RAPID THERMAL PROCESSED (RTP) SELECTIVE EMITTER SOLAR CELLS USING A SINGLE DIFFUSION STEP" 16TH. E.C. PHOTOVOLTAIC SOLAR ENERGY CONFERENCE. GLASCOW, UNITED KINGDOM, MAY 1 - 5, 2000, PROCEEDINGS OF THE INTERNATIONAL PHOTOVOLTAIC SOLAR ENERGY CONFERENCE, LONDON : JAMES & JAMES LTD, GB, Bd. VOL. 2 OF 3. CONF. 16, 1. Mai 2000 (2000-05-01), Seiten 1087-1090, XP001138826 ISBN: 1-902916-18-2 in der Anmeldung erwähnt**

**Beschreibung**

Die Erfindung bezieht sich auf ein Verfahren zum Ausbilden einer linien- und/oder punktförmigen Struktur auf einem Träger, insbesondere zum Ausbilden von streifenförmigen elektrisch leitenden Kontakten auf einem Halbleiterbauelement wie Solarzelle, durch Auftragen einer auf dem Träger haftenden elektrisch leitenden pastenförmigen ein Lösungsmittel enthaltenden Substanz und anschließendes Aushärten der Substanz. Bei der Herstellung elektronischer Bauelemente erfolgt das Aufbringen feiner elektrisch leitender Strukturen in erster Linie über physikalische oder chemische Gasphasenabscheidung, epitaktische Verfahren unter Verwendung von Masken oder eventuell mit zusätzlicher Laserunterstützung. Diese Techniken erlauben die Herstellung sehr feiner Strukturen, gleichwenn diese für eine kostengünstige Massenproduktion aus wirtschaftlichen Gründen kaum geeignet sind.

Andere Verfahren, um feine Strukturen aufzubringen, sind z. B. Siebdruck, Rollendruck oder Tampondruck. Auch wenn diese Verfahren unter wirtschaftlichen Gesichtspunkten attraktiv erscheinen, ist jedoch der Nachteil gegeben, dass nur eine begrenzte Auflösung der Strukturen erzielbar ist, so dass eine Verwendung grundsätzlich nur für größere elektronische Bauelemente mit gröberen Strukturen geeignet ist.

Bei der Herstellung von Solarzellen besteht hinsichtlich der strahlungszugewandten Seite die Anforderung, möglichst feine elektrisch leitende Strukturen aufzubringen, die eine gute elektrische Leitfähigkeit sowie einen guten elektrischen Kontakt zur Solarzelle, also zum Träger sicherstellen. Diese Forderung ergeht vor dem Hintergrund, dass die der Strahlung zugewandte Fläche so gering wie möglich abzuschatten ist. Um jedoch eine gute elektrische Leitfähigkeit mit hoher Stromableitung zu ermöglichen, müssen die entsprechenden Leiter einen großen Querschnitt aufweisen. Um diesen Forderungen zu genügen, werden nach dem Stand der Technik Kontakte häufig mittels Siebdruck aufgebracht. Voraussetzung hierfür ist jedoch, dass der Träger eine ebene Oberfläche aufweist, auf die die linien- bzw. streifenförmigen Kontakte aufgebracht werden. Auch epitaktische Verfahren gelangen zur Anwendung.

Bei einem weiteren bekannten Verfahren werden mittels eines Laserstrahls Vertiefungen in eine Solarzellenoberfläche eingebracht, die anschließend mittels chemischer Abscheideverfahren mit leitfähigem Material gefüllt werden (US-A-4,726,850). Allerdings ist ein entsprechendes Verfahren recht aufwendig und damit kostenträchtig.

In der WO-A-9324934 wird eine elektrisch leitende Paste auf einen Träger aufgebracht, wobei die Paste durch Bestrahlung mit UV-Licht polymerisiert und stabilisiert wird.

Um eine Struktur auf einem Plasmaschirm auszubilden, ist es nach der US-B-6,312,864 bekannt, eine Substanz mit durch Hitze zersetzendem Bindemittel aufzutragen, die sodann durch Temperatureinwirkung ausgehärtet wird.

Die US-B-6,322,620 schlägt das Aushärten einer Substanz auf einen Träger durch thermische Behandlung vor.

Druckverfahren zum Aufbringen von Strukturen auf einer Solarzelle sind den Literaturstellen zu entnehmen "Screen-Printed Rapid Thermal Processed (RTP) Selective Emitter Solar Cells Using a Single Diffusion Step", 16th European Photovoltaic Solar Energy Conference, 1-5 May 2000, Glasgow, UK, S. 1087-1090 und "High Quality Screen-Printed and Fired-Through Silicon Nitride Rear Contacts For Bifacial Silicon Solar Cells", 16th Europeän Photovoltaic Solar Energy Conference, 1-5 May 2000, Glasgow, UK, S. 1332 -1335.

Aus der JP-A-63268773 ist eine Paste bekannt, die lösungsmittelfrei ist und ein Edelmetallpulver, Glasfritte und Metalloxid sowie Bindemittel enthält.

Druckverfahren haben den grundsätzlichen Nachteil, dass bei geringer Linienbreite keine hohen Schichtdicken erzeugbar sind. Dies führt zu dem Nachteil, dass breitere Linien oder eine größere Anzahl dieser erforderlich sind, um die gewünschten niedrigen Widerstandswerte zu erzielen. Somit erfolgt eine unerwünschte Abschattung.

Fingerschreibsysteme, soweit diese bei der Strukturierung von Solarzellen zum Einsatz gelangen, sind grundsätzlich zur Erfüllung der Anforderungen geeignet. Allerdings hängt die Linienbreite stark von der Wechselwirkung der aufzubringenden Substanz, in der Regel in Form einer Paste, und den Oberflächeneigenschaften des Trägers ab. Paste und Träger beeinflussen das Ausbreiten ersterer nach dem Aufbringen im Wesentlichen. Dabei zeigen die aufgetragenen Strukturen in Form linearer Streifen die Tendenz zu verlaufen. Hierdurch bedingt vergröbert sich die aufgebrachte Struktur. Um diese Nachteile zu vermeiden, können feine Öffnungen des Fingerschreibsystems gewählt werden, wodurch jedoch das Risiko erwächst, dass die aufzubringenden Streifen abreißen. Die hohe Sensibilität des Prozesses auf die relevanten Prozessparameter führt daher dazu, dass die entsprechende Technik nur selten Anwendung findet.

Aus der US-B-6,312,864 ist ein Verfahren zur Ausbildung von elektrisch leitenden Streifen auf einem transparenten Träger wie Glas bekannt. Dabei werden die Streifen durch Fotolithografie hergestellt.

Der vorliegenden Erfindung liegt das Problem zu Grunde, ein Verfahren der eingangs genannten Art so weiterzubilden, dass elektrisch leitende Strukturen wie Leiterbahnen bzw. Kontakte auf einen Träger insbesondere eine Solarzelle aufgebracht werden können, wobei die Abschattung zu dem Träger minimiert werden soll. Gleichzeitig soll der Widerstand der Struktur gering sein. Auch soll das Verfahren für eine Massenproduktion, insbesondere bei der Herstellung von elektrisch leitenden Kontakten auf einem Halbleiterelement wie Solarzelle geeignet sein.

Zur Lösung des Problems sieht die Erfindung das Verfahren nach Anspruch 1 vor.

Dabei kann die pastenförmige Substanz auf den Träger z. B. mittels Siebdruck, Tampondruck, Sprühtechnik oder bevorzugterweise mittels Fingerschreibtechnik aufgebracht werden.

Erfindungsgemäß wird durch den Auftrag von Flüssigkeiten mit polaren Molekülen (Medien) auf die frisch aufgebrachte Kastenstruktur erreicht, dass feine Leiterbahnen herstellbar und aushärtbar sind, also das Auseinanderfließen des frisch aufgetragenen Pastenmaterials bzw. der Pastensubstanz verhindert bzw. eingeschränkt wird bzw. ein Zusammenziehen der Pastensubstanz erfolgt. Die Pasten bestehen aus Mischungen von Bindern, Lösungsmitteln, Dispergierstoffen und Metallpartikeln und glasartigen und/oder keramischen Körpern.

Durch die attraktive Wechselwirkung des Mediums am Rande und auf der Oberfläche der Paste werden die polaren Lösungsmittel aus der Paste extrahiert. Als allgemein gültigen Ansatz wird die Wechselwirkung zwischen den polaren Molekülen eines Mediums mit einem Dipolelement wie beispielsweise Wasser, Alkohol, Aceton und anderen polare Moleküle enthaltenden Medien mit dem polaren Lösungsmittel aus der Paste gesehen. Das Lösungsmittel diffundiert aus der Paste im Randbereich heraus und hinterlässt eine Randzone mit Verarmung an Lösungsmitteln. Dieses entspricht einer Härtung und verursacht dadurch eine Stabilisierung der Leiterbahnstruktur durch die Randschicht

Es konnte festgestellt werden, dass das Breiten-Höhenverhältnis der aufgebrachten Strukturen mit der pastenförmigen Substanz durch Wechselwirkung zwischen der Substanz und dem aufgetragenen Medium verändert werden kann. Bei dem Medium handelt es sich insbesondere um eine Lösung polarer Moleküle, die sowohl mit der Oberfläche der Substanz als auch der des Trägers wechselwirken.

Dabei kann durch Zugabe einer polare Moleküle enthaltenden Lösung als das Medium bewirkt werden, dass die pastenförmige Substanz kurz nach Auftragen auf den Träger in seinem Breiten-Höhenverhältnis im Querschnitt zugunsten größerer Höhen und geringerer Breiten verändert wird, so dass sich die gewünschte Feinheit der angestrebten punkt- oder linienförmigen Struktur einstellt. Durch die Wechselwirkung der beteiligten Substanzen kann eine den Anforderungen entsprechende feine Struktur elektrisch leitender pastenförmiger Substanzen aufgebracht werden, wobei zum Auftragen Verfahren zur Anwendung gelangen, die dem Stand der Technik zu entnehmen sind, also Siebdruck, Tampondruck, Sprühtechnik oder insbesondere mittels Fingerschreibsystem. Somit kann bei hohem Durchsatz kostengünstig eine gewünschte feine Struktur auf einem Träger wie Solarzelle aufgebracht werden.

Aufgrund der durch die erfindungsgemäße Lehre erzielbaren feinen Struktur, also schmalen Kontaktflächen zwischen pastenförmiger Substanz und Träger, ergibt sich nach dem Sintern ein Bereich auf dem Träger entlang der Substanzstruktur, der anfänglich, also vor dem Sintern mit der Substanz kontaktiert war, jedoch anschließend durch quasi Zusammenziehen der Substanz wieder freigelegt wird. Dieser zuvor abgedeckte und sodann wieder freigelegte Bereich ist optisch erfassbar und charakteristisch für die erfindungsgemäße Lehre.

Die Menge des aufgetragenen Mediums ist mit entscheidend für die Wirk- und Haltbarkeit des Effektes. Wenn zuviel Medium aufgetragen wird, kann es vorkommen, dass das Medium (z. B. Wasser, Alkohol) die aufgetragene Paste unterkriecht, d. h. auch von der Unterseite eine Härtung durch Auslaufen von Pastenlösungsmittel erfolgt. Dadurch wird aber der Klebeeffekt der Leiterbahn zum Substrat zerstört. Ziel ist es, zur Erhaltung der Formstabilität eine harte Schale und zur Erhaltung der Haftung am Substrat einen klebenden Kern der Leiterbahn zu erzeugen. Da die Auslösung des Lösungsmittels aus der Paste auch von der Menge des Mediums an der Berührungsfläche, d. h. an der Oberfläche der Paste abhängt, kann diese durch einen Schaum vermindert werden. Das Medium wird daher in einem verminderten Umfang auf den Träger gegeben, indem an z. B. ein Tensid zum Aufschäumen des Mediums einführt.

Das Zerfließen der pastenartigen Substanz wird auch auf andere Weise durch das Auftragen des die polaren Moleküle enthaltenden Mediums auf den Träger erreicht, wobei die Adhäsionskräfte des Mediums zum Träger größer als die Adhäsionskräfte zwischen der Substanz und dem Träger sind. Hierdurch bedingt wird ein Zer- bzw. Ausfließen der pastenförmigen Substanz gehemmt und diese kann sogar zurückgedrängt werden. Es zeigt sich ein quasi Zurückziehen der aufgebrachten Substanz mit der Folge, dass sich ein günstiges Höhen-/Breitenverhältnis einstellt.

Allerdings ist darauf zu achten, dass die Adhäsionskräfte zwischen dem Medium und dem Träger einerseits und der Substanz und dem Träger andererseits derart aufeinander abgestimmt werden, dass eine Unterwanderung der Substanz unterbleibt, da anderenfalls ein Ablösen der Substanz vom Träger erfolgen könnte. Somit muss sichergestellt sein, dass eine hinreichend gute Adhäsion der Substanz zum Träger gegeben ist. Gleichzeitig soll jedoch eine hinreichend schnelle Aushärtung der Oberfläche der Substanz erfolgen, wobei ein haftender Kernbereich verbleiben soll.

Mit anderen Worten ist durch das Einsetzen des Mediums sicherzustellen, dass ein Zerfließen der pastenförmigen Substanz nach Auftragen auf den Träger unterbunden wird, gleichzeitig jedoch eine hinreichende Haftung auf dem Träger sichergestellt ist, wobei gegebenenfalls ohne Einbußen des Kontaktes ein Zusammenziehen der Substanz ermöglicht werden soll.

Bei dem Träger handelt es sich insbesondere um ein Metall, bevorzugter Weise um ein Halbleitermaterial wie ein- und/oder multikristallines Silizium, Germanium, eine dünne Schicht aus amorphem Silizium oder Verbindungshalbleitern wie Cadmium-Tellurid oder Kupfer-Indium-Diselenid. Diese Materialien werden als Grundmaterial für die Herstellung von Solarzellen verwendet. Dabei ist es ein Hauptaspekt der Erfindung, feine metallische Strukturen auf der strahlungszugewandten Seite von Solarzellen bei geringer Abschattung und somit höherem Wirkungsgrad bei der Umwandlung von Licht in elektrische Energie zu erzielen. Allerdings soll hierdurch die erfindungsgemäße Lehre nicht eingeschränkt werden. Vielmehr lässt sich das erfindungsgemäße Verfahren auch zur Erzeugung feiner elektrisch leitfähiger Strukturen auf Isolatoren wie Glas- oder Keramiksubstanzen zur Anwendung bringen. Beispielhaft ist die Verwendung derartiger Strukturen zur Beheizung flächiger Träger zu nennen. Als Träger sind auch mit Isolationsschichten versehene metallische Materialien zu nennen, auf denen unter Zugrundelegung der erfindungsgemäßen Lehre elektrische Komponenten verschaltet werden können.

Die pastenförmige Substanz besteht im Wesentlichen aus einem oder mehreren Harzen, einem oder mehreren Lösungsmitteln sowie metallischen Pulvern wie Silber, Aluminium oder Bleiglas als Sinterhilfe sowie Glas und/oder Glaskeramik als Haftvermittler zum Träger. Die Substanz kann erwähntermaßen mittels Siebdruck, Fingerschreibgerät, Tampondruck etc. auf die Oberfläche des Trägers aufgetragen werden. Erfolgt ein gutes Benetzen der Trägeroberfläche, also bei guter Adhäsion zwischen der Substanz und dem Träger, so tritt nach dem Stand der Technik ein Ausfließen - auch Ausbluten genannt-der Substanz auf, so dass die Tendenz zur Verbreiterung der aufgetragenen Struktur wie Linien bzw. Streifen gegeben ist. Nach dem Stand der Technik kann dieser Verbreiterungstendenz durch Einstellung einer hohen Substanzviskosität teilweise entgegengewirkt werden. Dabei können thixotrope Pasten verwendet werden, deren Viskosität bei Anlegen einer Scherkraft herabgesetzt wird, im kräftefreien Zustand jedoch stark zunimmt.

Demgegenüber ist nach dem Hauptaspekt der Erfindung vorgesehen, dass das Ausfließen bzw. Ausbluten dadurch unterbunden bzw. eingedämmt wird, dass ein weiteres Medium wie Flüssigkeit oder eine solche enthaltend auf die Trägeroberfläche aufgebracht wird. Bei dem Medium handelt es sich um eine Flüssigkeit oder einen Schaum. Ein Aerosol ist gleichfalls denkbar. Um u. a. die Adhäsion zum Träger zu erhöhen, ist dem Medium vorzugsweise ein Tensid beigemischt. Wird die Adhäsion des Mediums zum Träger größer als die der pastenförmigen Substanz zum Träger, wird die Substanz zurückgedrängt und ein Zerfließen bzw. Ausbluten unterbunden. Insbesondere wird ein tensidisches Medium wie Wasser benutzt, das ein Tensid enthalten kann. Der Härtungsprozess funktioniert grundsätzlich auch mit Wasser ohne Tensid. Wasser sorgt für Härtung. Das Tensid sorgt für Schaumbildung und damit in erster Linie für die richtige Dosierung der Menge Wasser. Mit Hilfe des Schaums können daher feinere Strukturen aufgebracht werden.

Als Medium wird erwähntermaßen ein Lösungsmittel mit polaren Molekülen wie Wasser, Alkohol, Aceton eingesetzt, das das ebenfalls polare Lösungsmittel aus der Paste herauslöst.

Durch ein polares Lösungsmittel des Mediums wird eine attraktive Wechselwirkung mit dem Lösungsmittel der Paste erzeugt, die dazu führt, dass das Lösungsmittel der Paste extrahiert wird, d. h. in das Lösungsmittel, aus dem das Medium besteht, übergeht.

Dies sei an folgendem Beispiel erläutert. Das Dipolmoment von Wasser ist $6,07 * 10^{30}$ Cm. Das Dipolmoment des Pastenlösungsmittels z. B. von Alkoholen ist $5,5 - 5,8 * 10^{30}$ Cm. Bei Übereinstimmung der Dipolmomente der beiden Lösungsmittel kommt es zu einem Austausch infolge des Konzentrationsgradienten. Insofern kommt es überwiegend zum Austausch der beiden Flüssigkeiten derart, dass der Alkohol im Wasser in Lösung geht. Durch den Austausch der polaren Moleküle entsteht in der Randzone des Materials im Material eine Verminderung an Lösungsmittelanteil, was zu einer Kontraktion der aufgebrachten Paste führt. Dieses führt zur Formstabilität der aufgebrachten Leiterbahn.

Bei stark unterschiedlichen Konzentrationsgradienten kommt es entweder zu einem Austausch oder wie im Falle von Benzol, Hexan oder Schwefelkohlenstoff, Tetrachlorkohlenstoff (wasserunlöslich, da Dipolmoment 0) zu einer repulsiven Wechselwirkung. Hierbei wird die Substanz der Paste sogar zusammengedrückt und es kommt zu einer Verkleinerung der Leiterbahnbreite, wenn zusätzlich eine bessere Benetzung des Substrats durch das Medium gegeben ist. Das Tensid im Medium sorgt nicht nur für die Schaumbildung, es verringert die Oberflächenspannung zum Substrat und bewirkt eine bessere Benetzung des Substrates. Das tensidhaltige Medium benetzt das Substrat besser als die Paste und drückt damit die Paste zusammen.

Im einfachsten Fall ist das tensidische Medium eine Seifenlösung aus Wasser und Seife.

Um jedoch ein zu starkes Zurückdrängen der pastenförmigen Substanz zu unterbinden, wodurch es gegebenenfalls zu einer Zerlegung der Leiterbahn in einzelne Tropfen und damit zu Unterbrechungen kommen könnte, kann die pastenförmige Substanz Bestandteile aufweisen, die mit dem Medium chemisch reagieren, um eine mechanisch stabile Oberfläche oder Haut auszubilden. Diese Haut stabilisiert die Form der pastenförmigen Substanz und verhindert somit eine Tropfenbildung. Im Inneren der pastenförmigen Substanz bleibt jedoch unreagiertes Material zurück, wodurch die Haftung der pastenförmigen Substanz an der Oberfläche des Trägers aufrechterhalten wird.

Bei dünn aufgetragenen Strukturen wie Leiterbahnen mit Durchmessern von z. B. 100 $\mu$m kann sogar eine Reaktion bis zum Kern der Substanz erfolgen, so dass eine komplette Härtung erzielt wird. Diese Härtung führt zu einer stabilen Form innerhalb weniger Sekunden. Erwähntermaßen muss jedoch darauf geachtet werden, dass die Haftung zwischen der Substanz und dem Träger beibehalten wird, da andernfalls eine Ablösung erfolgen würde.

Des Weiteren können in der Substanz wasserlösliche (polare) und wasserunlösliche (nicht-polare) Lösungsmittel enthalten sein. Die wasserunlöslichen Lösungsmittel stellen dabei sicher, dass die Pasteneigenschaften beibehalten werden durch das Lösungsmittel, ohne dass dieses jedoch durch das Medium extrahiert wird. Hierdurch ist ein gezieltes Aushärten der Außenschicht der Substanz möglich. Ein Unterwandern der Substanz von dem Medium kann hierdurch zusätzlich unterbunden werden.

Unabhängig hiervon erfolgt nach dem Stabilisieren der Paste, d. h. dem Unterbinden des Ausfließens, in gewohnter Weise ein Trocknen bzw. Sintern, um die Metallpartikel der Substanz in den Träger einzubrennen.

Für das Aspektverhältnis Höhe: Breite der pastenförmigen Substanz sind Adhäsionskräfte, Kohäsionskräfte und Fließkräfte der Substanz ausschlaggebend. Eine wesentliche Rolle spielen dabei die Adhäsionskräfte zwischen der Substanz und Oberfläche des Trägers. Entscheidend hierfür sind die organischen Komponenten der Substanz wie Harze sowie Lösungsmittel.

Weitere Einzelheiten, Vorteile und Merkmale der Erfindung ergeben sich nicht nur aus den Ansprüchen, den diesen zu entnehmenden Merkmalen, sondern auch anhand der im Zusammenhang mit den der Zeichnung zu entnehmenden Ausführungsbeispielen sowie den zugehörigen Erläuterungen.

Es zeigen:

Fig. 1     einen Querschnitt durch eine linienförmige Struktur, hergestellt aus einer pastenförmigen Substanz,

Fig. 2     eine Draufsicht auf einen Träger mit auf diesem haftender linienförmiger Struktur,

Fig. 3     eine Prinzipdarstellung der auf einen Träger aufgebrachten linienförmigen Struktur nach dem Auftragen auf einen Träger bzw. nach dem Sintern gemäß Fig. 2,

Fig. 4     einen Graph zur Verdeutlichung des Höhen-Breitenverhältnisses aufgetragener Strukturen,

Fig. 5     Prinzipdarstellungen von auf einem Träger aufgetragenen Leiterbahnen und

Fig. 6     Prinzipdarstellungen zur Verdeutlichung des Zusammenziehens von Leiterbahnen auf einem Träger.

Die erfindungsgemäße Lehre wird bevorzugterweise zur Verbesserung des Wirkungsgrades von Solarzellen auf der Basis von kristallinen Silizium-Substanzen verwendet, ohne dass hierdurch jedoch eine Einschränkung erfolgen soll.

Siliziumscheiben, die mit einer Oberflächenschicht aus $SiO_x$ mit $x \leq 2$, oder $Si_3N_x$ mit $x \leq 4$ versehen sind, die der Reduzierung der Reflexion auf einer Strahlung dienen, werden Luft bzw. feuchter Luft ausgesetzt. Im Anschluss an eine derartige Behandlung ist eine Aktivierung der Trägeroberfläche festzustellen, die mit der Erzeugung elektrisch aktiver Zentren an Bindungen des Siliziums bzw. des $Si_3N_x$ erklärt werden können. Die entsprechende Behandlung erfolgt bevorzugterweise bei einer Temperatur T mit in etwa 30 °C $\leq$ T $\leq$ in etwa 60 °C über einen Zeitraum t mit bevorzugterweise in etwa 15 Minuten $\leq$ t $\leq$ in etwa 90 Minuten. Die relative Luftfeuchtigkeit sollte zwischen 40 % und 90 % liegen. Alternativ kann eine Aktivierung der Oberfläche des Trägers, also der Solarzelle durch Exposition gegenüber einer ozonhaltigen Atmosphäre oder durch zusätzliche Behandlung mit UV-Licht verstärkt werden oder durch eine Koronaentladung entlang der Oberfläche. Eine verstärkende Wirkung kann auch durch anschließende oder parallele Behandlung mit einer Koronaentladung erreicht werden.

Auf die entsprechend behandelte Oberfläche des Trägers, also im Ausführungsbeispiel der Solarzelle wird eine pastenförmige Substanz - nachstehend kurz Paste genannt-aufgetragen. Nach einem Aspekt der erfindungsgemäßen Lehre weist die elektrisch leitende Paste kurzkettige organische Substanzen auf, die über ein stärker elektronegatives Ende verfügen. Hierdurch wird die Paste in einen Zustand versetzt, der es ermöglicht, die durch die elektronegativen Enden bedingte Oberflächenladung der Paste nach Aufbringen auf den Träger in Wechselwirkung mit der aktivierten Schicht auf den Träger zu bringen. Je nach Einstellung der Paste, d. h. Stärke der Wechselwirkung, neigt diese dazu, auf der Substanz auseinander zu laufen, oder zu einer geringen Kontaktfläche. Das Auseinanderlaufen der Paste erfolgt aufgrund eines kleinen Benetzungswinkels zwischen der Paste und Trägeroberfläche. Ohne zusätzliche Maßnahmen würde dies zu einer ungewollt breiten metallischen Struktur führen, die allerdings gute Haftungseigenschaften zur Trägeroberfläche aufweisen würde. Ein Zerfließen der Paste würde dann unterbunden werden, wenn sich zwischen der Paste und dem Träger abstoßende Kräfte ausbilden, wodurch ein großer Benetzungswinkel entstehen würde, der dazu führt, dass die aufgetragenen Strukturen aufgrund mangelnder Haftung sich ablösen können.

Erfindungsgemäß wird durch Zugabe eines weiteren Mediums einerseits das Zerfließen unterbunden bzw. eingedämmt und andererseits ein Lösen der Paste von dem Träger verhindert, so dass schmale Strukturen erzielbar sind. Das Medium wechselt mit der Paste derart, dass einerseits ein Zusammenziehen der aufgebrachten Pastenstruktur erfolgt, andererseits die Festigkeit zu dem Träger nicht nachteilig beeinflusst wird.

Als Medium wird eine Flüssigkeit, bevorzugterweise ein Schaum verwendet, die bzw. der unmittelbar nach Auftragen der Paste auf den Träger aufgebracht wird. Dabei weist das Medium eine Zusammensetzung derart auf, dass die Adhäsionskräfte zwischen diesem und dem Träger größer als die Adhäsionskräfte zwischen der Paste und dem Träger sind. Hierdurch bedingt wird durch das Medium die Paste quasi zurückgedrängt mit der Folge, dass einem Auseinanderfließen entgegengewirkt wird. Dabei konnte sogar festgestellt werden, dass die Struktur aufgrund der wirkenden Adhäsionskräfte in der Breite verringert wird, also die Paste in ihrer Breite verschmälert wird. Außerdem enthält die Paste Bestandteile, die bewirken, dass nach dem Auftragen der Paste auf den Träger zumindest eine Oberflächenhärtung mit der Folge eintritt, dass ein Verbreitern unterbunden wird, da die aufgetragene Paste, also deren Geometrie, durch die Oberflächenaushärtung beibehalten wird.

Die Paste kann aus mehreren organischen Komponenten wie Harzen und Lösungsmitteln, verschiedenen Bindern und Dispergiermitteln in fester und/oder flüssiger Form sowie organischen Feststoffen wie z. B. einem Gemisch aus Metallen wie Kupfer, Silber, Aluminium, Blei, Zinn, Lotlegierungen sowie Kombinationen hieraus und aus Kombination anderer, auch nicht-metallischer Stoffe wie Aerosole aus Siliziumoxid, Siliziumnitrid, Zinkoxid, Ruß-/Graphitteilchen bzw. diese Komponenten enthaltenden Pulvern sowie anorganischen Sinterhilfen zusammengesetzt sein. Ferner können niedrigschmelzende Glaslegierungen oder anorganische Substanzen wie Glas, bleihaltiges Glas, Bor- oder Phosphorsilikatglas, oder Metalloxide als Sinterhilfe, Schmelzpunkterniedriger, Haftvermittler während des Sinterprozesses, Flussmittel etc. der Paste zugegeben werden.

Ferner werden organische Komponenten wie Polymere (Harze) und organische Lösungsmittel hinzu gegeben. Insbesondere können die organischen Komponenten einer Paste enthalten:

- Binder wie Acryl- und Polyesterharze, Chloropene, Ethylcellulose, Ethylene, Polyethylene, Furane, Polyvinylchlorid, Alkydharze, Epoxidharze, Epoxidester, Polyurethane, Butadiene, Silikone und Mischungen daraus,
- Lösungsmittel wie Dimethylester, Butylester, Wasser, Alkohole, Ethanol, Propanol, Butanol, Aceton, Terpentin, Benzol, Benzin,
- Vernetzungsmittel wie Melamine, Phenolharze, Benzoguanamine, Harnstoffvernetzer,
- Härter,
- Schichtbildner wie Polyvinylbutyral,
- Benetzungsmittel,
- rheologische Komponenten,
- Polymer-Modifikatoren wie Plasticizer.

Beispielhaft kann die Paste aus einem Binder Ethylzellulose gelöst in Buthyldiglykol, verschiedenen Bindern unterschiedlicher Kettenlängen und Zusätzen, die einen Einfluss auf die Fließfähigkeit der Paste besitzen sollen, bestehen. Eine entsprechende in geeigneter Viskosität eingestellte Paste kann nach einem gewünschten Aufbringungsverfahren wie Siebdruck, Schablonendruck oder Fingerschreibverfahren auf den Träger wie der Solarzelle aufgetragen werden.

Erfolgt ein Auftragen nach der Fingerschreibtechnologie, so besitzt die Paste zunächst einen kreisförmigen Querschnitt. Durch die Bewegung des Trägers relativ zur Austrittsdüse des Fingerschreibsystems wird die Paste in die Länge gezogen. Dabei sollen Viskosität der Paste und Geschwindigkeit des Vorschubs des Trägers so eingestellt werden, dass sich ein Pastenfaden mit einem Durchmesser zwischen 50 $\mu$m und 300 $\mu$m, vorzugsweise 80 $\mu$m ergibt. Selbstverständlich können auch das Fingerschreibsystem zu dem Träger oder diese zueinander bewegt werden.

Um das ansonsten auftretende unerwünschte Verbreitern des Streifens zu unterbinden, erfolgen innerhalb der ersten Sekunden nach dem Auftragen erfindungsgemäß vorgeschlagene Maßnahmen. So kann der Träger bzw. der Pastenstreifen unmittelbar nach dessen Auftragen auf den Träger in Kontakt gebracht werden mit:

- einem Feststoff wie einem feinen Pulver, das das Lösungsmittel an der Pastenoberfläche bindet und eine verschließbare Haut bildet,
- einer Flüssigkeit oder einem Gas, entweder allein oder in Kombination, die bzw. das mit dem Lösungsmittel oder dem Harz der Paste reagiert,
- elektrischen Entladungen, die ein Plasma erzeugen, das zur Oberflächenhärtung der Paste führt,
- elektromagnetischer Strahlung wie Kunststoff härtendes UV-Licht oder IR-Strahlung mit schnelltrocknender Wirkung, um die Oberfläche auszuhärten.

Insbesondere wird der Pastenstreifen unmittelbar nach seinem Auftragen auf den Träger mit einer Wasser enthaltenden Flüssigkeit wie Schaum in Kontakt gebracht. Der Schaum löst aus dem Pastenmaterial das organische Lösungsmittel heraus und bewirkt dadurch eine mechanische Veränderung wie eine Härtung der Oberfläche. Die Oberfläche bildet somit eine zähe Haut oder Kruste aus, so dass ein weiteres Ausfließen des Pastenmaterials verhindert wird. Zusammen mit dem Feststoffgehalt der Paste bildet sich eine feste Kruste.

Im Ausführungsbeispiel wird das organische und zugleich wasserlösliche Lösungsmittel Butyldiglykol durch den Kontakt mit den Medien wie tensidhaltiger Wasserlösung zu 80 % bis 100 % entfernt. Dies führt zu einer Oberflächenhärtung wie Krustenausbildung.

Werden z. B. Stege einer Breite von 100 $\mu$m aufgetragen, so kann eine durchgehende Härtung auftreten. Um zu vermeiden, dass der komplett gehärtete Steg von dem Träger abgelöst wird, werden erfindungsgemäß neben den wasserlöslichen Lösungsmitteln auch wasserunlösliche Lösungsmittel zugegeben, wodurch einerseits die gewünschte Aushärtung erfolgt und andererseits die Haftungseigenschaften zum Träger beibehalten werden.

Erfindungsgemäß werden folglich in Verbindung mit dem tensidischen Medium härtende und nicht härtende Harz-Lösungsmittel-Gemische unter Zumischung von Metallpulvern zu Pasten verarbeitet, die in den Randbereichen einer Kontaktstelle zu dem Medium wie Wasser enthaltende Flüssigkeit oder Schaum aushärten. Die Komponenten der Pasten werden so zusammengemischt, dass ein Teil der Paste ein wasserlösliches Lösungsmittel, der andere Teil ein wasserunlösliches Lösungsmittel enthält. Nach Auftragen der Pastenmischung führt die Reaktion mit dem Medium wie Schaum zur Austragung von wasserlöslichem Lösungsmittel aus Teilbereichen der Paste und damit zur Härtung. Die anderen Teile der Paste bleiben unverändert, und zwar diejenigen, die wasserunlösliche Lösungsmittel enthalten, und stellen somit die Hafteigenschaften zu dem Träger sicher.

Nach einem weiteren Vorschlag der Erfindung kann der Paste eine UV-härtende Komponente zugegeben werden. Das Auftragen der Paste auf den Träger wird unter Einwirkung von UV-Licht durchgeführt, wodurch eine Härtung der Paste in ihrer Oberfläche erfolgt. Im Inneren der Paste verbleibt ein weicher Kern, der die ursprünglichen Haftungseigenschaften ermöglicht. Die Eindringtiefe des UV-Lichtes liegt je nach Absorptionseigenschaften der organischen Haftmischung im Bereich von 100 nm bis 1 $\mu$m, wobei durch die Metallpartikel in der Paste ein weiteres Eindringen der Strahlung verhindert wird.

Nach Auftragen der punkt-, linien- bzw. streifenförmigen Paste und deren erfindungsgemäße Beeinflussung zum Vermeiden eines Aus- bzw. Zerfließens erfolgt in gewohnter Weise ein Trocknen und anschließendes Sintern.

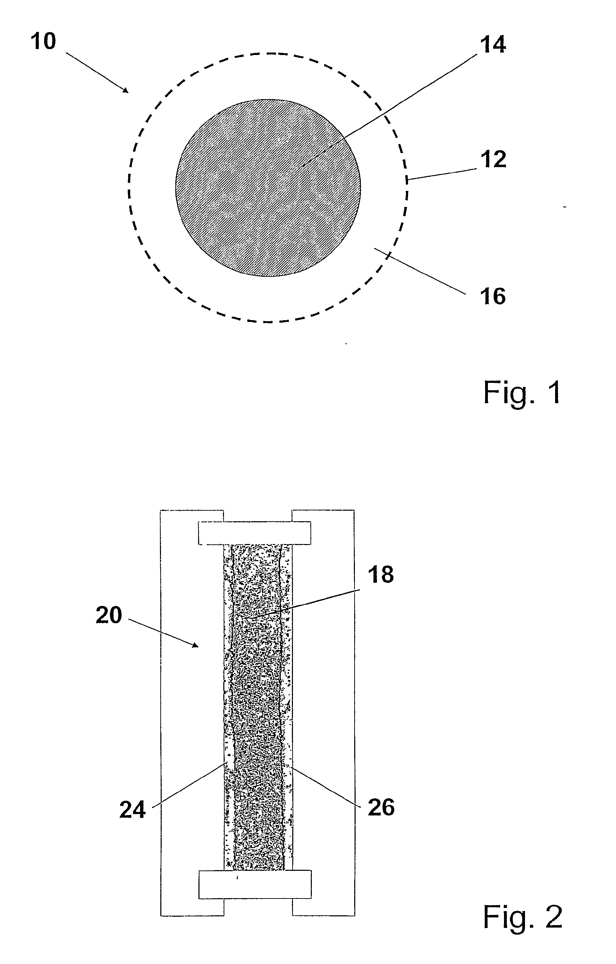

Untersucht man erfindungsgemäß auf einem Träger aufgebrachte Strukturen, so ist festzustellen, dass die Abdeckung der ursprünglich auf einem Träger aufgebrachten Paste nach dem Sinterprozess eine geringere Fläche des Trägers abdeckt als unmittelbar nach dem Auftragen auf diesen. Dies sei anhand der Fig. 1 bis 3 verdeutlicht.

So ist in Fig. 1 eine Prinzipdarstellung einer auf einem Träger aufgebrachten punktförmigen Struktur 10 wiedergegeben. Die Fläche, die die Paste unmittelbar nach Auftragen auf den Träger abdeckt, ist durch den äußeren Kreis 12 symbolisiert. Durch das unmittelbar nach dem Auftragen der Paste auf den Träger aufgebrachte Medium, insbesondere in Form eines tensidhaltigen Schaums, wird die Paste von dem Träger zurückgedrängt, so dass die Struktur nach dem Sintern eine in Fig. 1 schattiert dargestellte Fläche 14 abdeckt. Auf dem Träger selbst ist sodann ein schwacher, die Fläche 14 umgebender Ring 16 erkennbar, der ursprünglich vom Pastenmaterial bedeckt war. Durch das erfindungsgemäße Verfahren erfolgt eine Verfeinerung der punktförmigen Struktur.

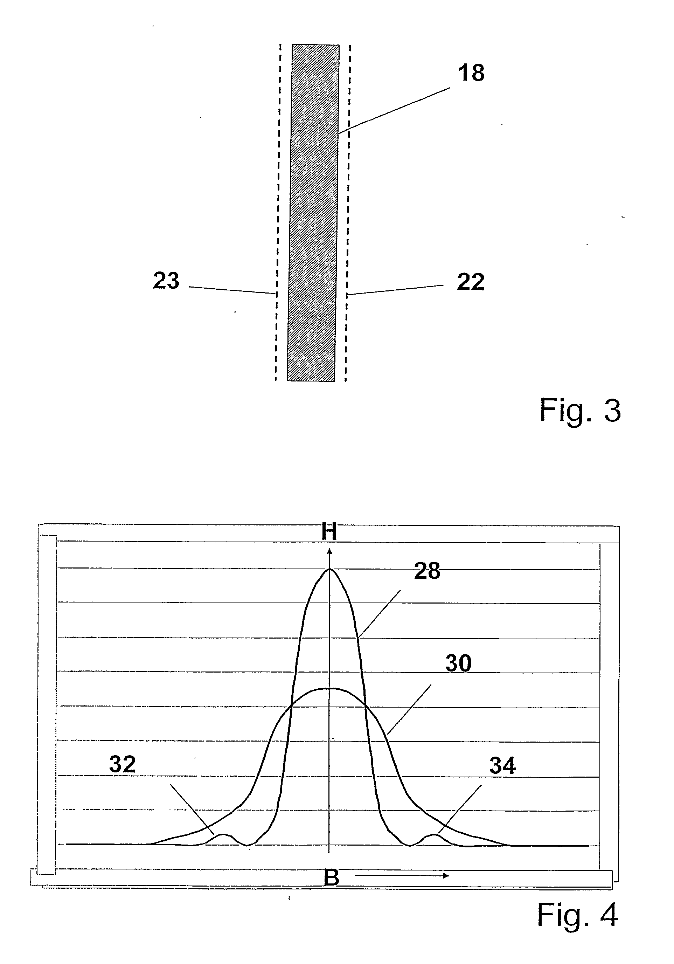

Gleiches gilt in Bezug auf eine linienförmig aufgebrachte Struktur 18, wie die Fig. 2 und 3 verdeutlichen. Fig. 2 ist eine Fotografie eines auf einer Solarzelle 20 aufgebrachten pastenförmigen Streifens, dessen Breite nach dem Sintern dem schraffierten Bereich, also der Struktur 18 gemäß Fig. 3 entspricht. Ursprünglich weist der Streifen eine Breite auf, der in Fig. 3 durch die gestrichelten Linien 22, 23 und in Fig. 2 durch die Streifen 24, 26 zuzüglich der Endstruktur 18 verdeutlicht wird.

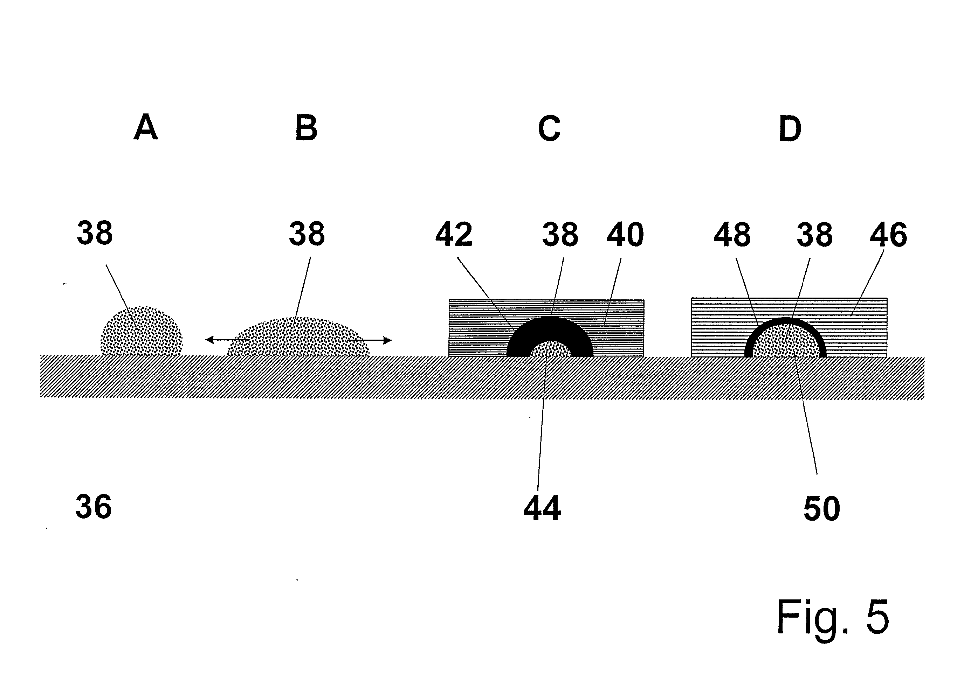

Die Fig. 5 soll prinzipiell verdeutlichen, wie eine auf einen Träger 36 aufgetragene Leiterbahn 38 die Tendenz zeigt zu zerfließen bzw. aufgrund der erfindungsgemäßen Lehre Letzteres unterbunden bzw. eingeschränkt wird. So ist in der Darstellung A die Leiterbahn 38 unmittelbar nach deren Auftragen auf den Träger 36 dargestellt. Die Darstellung B, die die Leiterbahn nach einer Zeit $\Delta$t nach dem Auftragen darstellt, verdeutlicht die Tendenz der Leiterbahn 38 zum Ausbreiten. Entsprechend hergestellte Leiterbahnen weisen daher eine relativ große Breitenerstreckung mit der Folge auf, dass der Träger 36 erheblich abgeschattet wird. Erfindungsgemäß ist nun vorgesehen, dass nach einer Zeit $\Delta$t nach dem Auftragen der Leiterbahn 38, wobei die Zeitspanne im Bereich zwischen 0,1 s und 10 min liegen kann, auf den Träger 36 sowie die Leiterbahn 38 ein polare Moleküle enthaltendes Medium 40 aufgetragen wird. Bei dem die polaren Moleküle enthaltenden Medium kann es sich um Wasser, Alkohol, Aceton oder Gemische dieser handeln, um nur beispielhaft Medien zu nennen. Da die Pastensubstanz der Leiterbahn 38 Lösungsmittel enthält, wird dieses zumindest teilweise in das Medium 40 extrahiert, wodurch ein lösungsmittelfreier Rand 42 in der Paste, d. h. in der Leiterbahn 38 entsteht. Der Rand 42 ist mechanisch hart (stabil). Zum Träger 36 hin, also im Bodenbereich der Leiterbahn 38 besteht eine schmale Zone 44 mit weiterhin klebendem Pastenmaterial, so dass der Kontakt zum Träger und das Haften der Leiterbahn 38 auf dem Träger 36 sichergestellt ist.

In der Darstellung D wird die Leiterbahn 38 nach einer Zeit $\Delta$t nach dem Auftragen auf den Träger 36 ebenfalls mit einem polare Moleküle enthaltenden Medium 46 versehen, d. h. das Medium 46 wird auf den Träger 36 und auf die Leiterbahn 38 aufgebracht. Bei dem Medium 46 handelt es sich im Beispiel D um einen Schaum. Insbesondere enthält das Medium 46 zur Bildung des Schaums ein Tensid. Durch den Schaum bedingt erfolgt eine Dosierung der Aufgabemenge des Mediums 46 mit der Folge, dass die Menge am Medium 46 am Rand der Leiterbahn 38, also der Oberfläche der Pastensubstanz verringert wird, so dass infolgedessen sich auch die Wechselwirkung in der Randzone der Pastensubstanz mit dem Medium verkleinert. Unabhängig hiervon erfolgt jedoch ein Extrahieren des Lösungsmittels aus der Substanz, so dass ein schmaler Rand 48 mechanisch stabil wird. Gleichzeitig ergibt sich jedoch der Vorteil, dass ein größerer klebender Pastenkern 50 verbleibt, der eine bessere Haftung an dem Träger 36 sicherstellt.

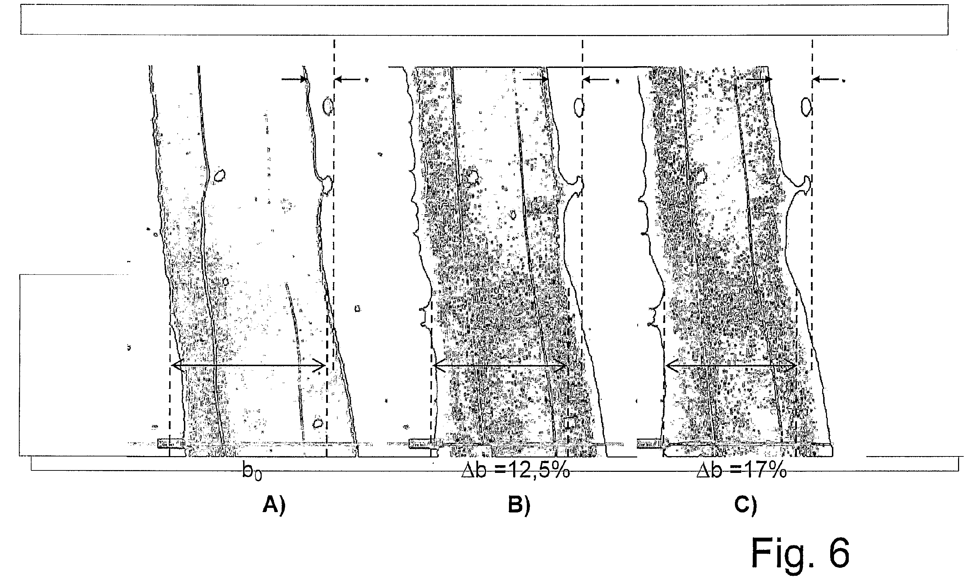

Anhand der Fig. 6 soll ein weiterer Aspekt der Erfindung erläutert werden, der nicht nur auf dem Gedanken beruht, dass zum Aushärten der Substanz Lösungsmittel extrahiert wird, sondern die Wechselwirkung von Medium, das polare Moleküle enthält, und dem Träger einerseits und der Substanz und dem Träger andererseits nutzt. So ist in Fig. 6 A) eine Leiterbahn kurz nach Auftragen auf einen Träger dargestellt. Dabei weist die Leiterbahn eine Breite $b_0$ auf. Nach 1 Minute hat sich die Breite um 12,5 % bezogen auf die ursprüngliche Breite $b_0$ und nach 3 Minuten um 17 % bezogen auf die Breite $b_0$ zusammengezogen. Dieses Zusammenziehen wurde dadurch bewirkt, dass ein Medium benutzt wird, dessen Adhäsionskräfte zum Träger stärker als die Adhäsion der Substanz zum Träger sind. Um dies zu erreichen, wird eine Substanz (Paste) benutzt, die neben polarem Lösungsmittel auch ein nicht polares Lösungsmittel enthält, das ein Dipolmoment gleich Null oder ein sehr kleines Dipolmoment aufweist. Beispielsweise können zwei Pasten gemischt werden, von denen eine Paste ein nichtpolares Lösungsmittel und die andere Paste ein polares Lösungsmittel enthält. Durch das Vorhandensein von nicht polarem Lösungsmittel Führt die Ausdiffusion des polaren Lösungsmittels nicht zur vollständigen Härtung der Substanz, d. h. zur Verkrustung des Randes der Leiterbahn. Das nicht-polare Lösungsmittel verringert den Härtungseffekt am Rand und bewirkt eine Verformbarkeit der Leiterbahn, wie dies aus einem Vergleich der Fig. 6A), 6B) und 6C) erkennbar ist.

Ferner wirken die Anteile des nicht-polaren Lösungsmittels in der Substanz auch gegen ein Unterkriechen der Substanz, also der Leiterbahn durch das Medium, da die Klebereigenschaften des nicht gehärteten Pastenkerns erhalten bleiben.

Anhand der Fig. 4 sollen gleichfalls die Unterschiede zwischen auf einem Träger auf gebrachten streifenförmigen Strukturen nach dem Stand der Technik und der erfindungsgemäßen Lehre verdeutlicht werden.

So ist in Fig. 4 Höhe und Breite von auf einer Siliziumsolarzellenoberfläche als Träger aufgebrachten streifenförmigen Kontakten dargestellt, wobei die Kurve 28 einen Kontakt symbolisiert, der nach der erfindungsgemäßen Lehre aufgetragen worden ist und die Kurve 30 einen solchen nach dem Stand der Technik. Die Einheiten von Höhe H und Breite B sind in Ordinaten und Abszisse unterschiedlich gewählt.

Der mit einem Fingerschreibverfahren auf die Siliziumsolarzelle aufgetragene Kontakt entsprechend der Kurve 28 weist eine Breite von in etwa 50 $\mu$m bis 200 $\mu$m, vorzugsweise 90 $\mu$m bis 110 $\mu$m bei einer Höhe H von 5 $\mu$m bis 50 $\mu$m, vorzugsweise 30 $\mu$m auf. Die nach dem Sintern auf der Solarzellenoberfläche feststellbaren Seitenstrukturen 32, 34, die in Fig. 2 den Streifen 24, 26 entsprechen, weisen einen Abstand von in etwa 150 $\mu$m bei einer Höhe zwischen 0,2 $\mu$m bis 200 $\mu$m auf.

Das Aspektverhältnis zwischen Höhe und Breite reicht von 0,1 bis in etwa 1 und beträgt typischerweise

$$33 \ \mu\mathrm{m} : 110 \ \mu\mathrm{m} = 0{,}3 \ .$$

Der im Siebdruckverfahren auf einer Siliziumsolarzelle konventionell aufgebrachte Kontakt entsprechend der Kurve 30 weist demgegenüber eine Breite von etwa 50 $\mu$m bis 300 $\mu$m, vorzugsweise 200 $\mu$m auf. Die Steghöhe beläuft sich zwischen 5 $\mu$m bis 25 $\mu$m. Somit ergibt sich ein Aspektverhältnis von Höhe zu Breite zwischen 0,02 bis 0,2 und liegt typischerweise bei

$$14 \ \mu\mathrm{m} : 200 \ \mu\mathrm{m} = 0{,}07 \ .$$

Aufgrund der erfindungsgemäßen Lehre kann durchschnittlich eine Verfeinerung der Linienbreite um 20 $\mu$m bis 50 $\mu$m gegenüber ursprünglicher Auftragbreite erzielt werden. Charakteristisch sind die Seitenstrukturen, die auf das Zusammenziehen des Streifens zurückzuführen sind.

Beispielhaft ist auszufahren, dass bei einer ursprünglichen Breite von in etwa 130 $\mu$m die Endbreite, also nach dem Sintern, in etwa 80 $\mu$m betrug. Mit anderen Worten wurde bei der Verwendung eines ein Tensid enthaltenden Schaums dieser derart aufgetragen, dass ein Herauslösen des Lösungsmittels aus Pasten und ein Aushärten der Oberfläche in einer Art und in einer Zeitspanne erfolgte, dass eine Breitenreduzierung in zuvor aufgezeigtem Umfang auftrat.

Das erfindungsgemäße Verfahren lässt sich grundsätzlich für verschiedene Materialpaarungen verwenden, bei denen eine Struktur mittels metallhaltiger Pasten auf metallischen Substanzen aufgebracht und eine Linienbreite von $\leq 150$ $\mu$m erzeugt werden soll. Dies gilt insbesondere auch für abgeschiedene Halbleiterschichten auf amorphem Silizium, Cadmium-Tellurid-Verbindungen oder Kupfer-Indium-Diselenid-Verbindungen auf Glasträgern, die zuvor mit einer leitfähigen Schicht bedeckt worden sind.

**Patentansprüche**

1. Verfahren zum Ausbilden einer linien- und/oder punktförmigen Struktur auf einem Träger, insbesondere zum Ausbilden von streifenförmigen elektrisch leitenden Kontakten auf einem Halbleiterbauelement wie einer Solarzelle, mit folgenden Schritten:

A) Bereitstellung einer elektrisch leitenden pastenförmigen Substanz, aus der durch Aushärten die auf dem Träger haftenden elektrisch leitfähigen Kontakte gebildet werden können, wobei die pastenförmige Substanz ein polares Lösungsmittel enthält, und Bereitstellung eines polaren Moleküle enthaltenden Mediums, wobei das Medium eine Flüssigkeit, ein Schaum oder ein Aerosol ist,
B) Auftragen der pastenförmigen Substanz auf den Träger sowie Auftragen des Mediums auf die pastenförmige Substanz derart, dass das Medium auf die pastenförmige Substanz einwirken kann und während des Einwirkens durch Wechselwirkung des polaren Mediums mit dem polaren Lösungsmittel, das in der Oberfläche der pastenförmigen Substanz vorliegt, polares Lösungsmittel aus der pastenförmigen Substanz extrahiert wird, sodass eine Härtung der Oberfläche der pastenförmigen Substanz eintritt,

C) Aushärten der pastenförmigen Substanz, wobei aus der Substanz die auf dem Träger haftenden, elektrisch leitenden Kontakte gebildet werden.

2. Verfahren nach Anspruch 1,
**dadurch gekennzeichnet,**
**dass** Adhäsionskräfte zwischen dem Medium und dem Träger grösser als Adhäsionskräfte zwischen der Substanz und dem Träger sind.

3. Verfahren nach zumindest einem der vorhergehenden Ansprüche,
**dadurch gekennzeichnet,**
**dass** als Medium ein tensidisches Medium mit Wasser und zumindest einem Tensid aus der Gruppe anionische Tenside, kationische Tenside, amphotere Tenside, nichtionische Tenside verwendet wird.

4. Verfahren nach Anspruch 3,
**dadurch gekennzeichnet,**
**dass** das tensidische Medium in Form einer Flüssigkeit oder eines Schaums im Bereich der aufgetragenen pastenförmigen Substanz auf den Träger aufgebracht wird.

5. Verfahren nach Anspruch 1,
**dadurch gekennzeichnet,**
**dass** die pastenförmige Substanz auf den Träger mittels Siebdruck, Tampondruck, Fingerschreibtechnik und/oder Sprühtechnik aufgebracht wird.

6. Verfahren nach Anspruch 1,
**dadurch gekennzeichnet,**
**dass** das Medium innerhalb eines Zeitintervall $\Delta t$ nach Auftragen der Substanz auf den Träger aufgebracht wird, wobei das Zeitintervall $\Delta t$ in etwa 0,1 sec bis in etwa 600 sec, vorzugsweise in etwa 1 sec bis in etwa 60 sec beträgt.

7. Verfahren nach zumindest einem der vorhergehenden Ansprüche,
**dadurch gekennzeichnet,**
**dass** als Substanz eine Paste mit kreisförmigem Querschnitt auf den Träger aufgebracht wird, wobei die Paste einen Durchmesser d mit insbesondere 50 $\mu m \leq d \leq 300 \mu m$, vorzugsweise von in etwa 80 $\mu m$ aufweist.

8. Verfahren nach Anspruch 1,
**dadurch gekennzeichnet,**
**dass** der Substanz wasserlösliche und wasserunlösliche Lösungsmittel zugegeben werden.

9. Verfahren nach Anspruch 1,
**dadurch gekennzeichnet,**
**dass** die Substanz derart punkt- bzw. linien- oder streifenförmig auf den Träger aufgetragen wird, dass die ausgehärtete Substanz ein Höhen zu Breitenverhältnis a mit insbesondere 0,1 < a < 1,0, insbesondere a in etwa 0,3 aufweist.

10. Verfahren nach Anspruch 1,
**dadurch gekennzeichnet,**
**dass** als Träger ein Siliziumsubstrat mit einer Oberflächenschicht bestehend aus Siliziumoxid und/oder Siliciumnitrid verwendet wird.

11. Verfahren nach Anspruch 3,
**dadurch gekennzeichnet,**
**dass** als anionische Tenside Seife, Fettalkoholsulfate oder Alkylbenzolsulfonate verwendet werden.

12. Verfahren nach Anspruch 3,
**dadurch gekennzeichnet,**
**dass** als kationische Tenside Invertseife verwendet wird.

13. Verfahren nach Anspruch 3,
**dadurch gekennzeichnet,**
**dass** als nichtionische Tenside Noncarbonsäureester von Polyalkoholen verwendet werden.

**Claims**

1. Process for the formation of a structure in form of lines and/or of dots on a support, in particular for the formation of electrically conductive contacts in the form of strips on a semiconductor device such as a solar cell, with the following steps:

A) Provision of an electrically conductive paste substance from which the electrically conductive contacts adhering on the support can be formed by hardening, wherein the paste substance comprises a polar solvent, and
Provision of a medium containing polar molecules, wherein the medium is a liquid, a foam or an aerosol,
B) Application of the paste substance to the support and application of the medium to the paste substance in such a way that the medium can act on the paste substance and that during said acting on the paste substance, via interaction between the polar medium and the polar solvent being present in the surface of the paste substance, polar solvent is extracted from the paste substance in such a way that a hardening of the surface of the paste substance results,
C) Hardening of the paste substance, wherein the electrically conductive contacts adhering on the support are formed from the substance.

2. Process according to Claim 1,
**characterized in that**
adhesion forces between the medium and the support are greater than adhesion forces between the substance and the support.

3. Process according to at least one of the preceding claims,
**characterized in that**
the medium used comprises a surfactant medium with water and with at least one surfactant from the group of anionic surfactants, cationic surfactants, amphoteric surfactants and non-ionic surfactants.

4. Process according to Claim 3,
**characterized in that**
the surfactant medium is applied in the form of a liquid or of a foam to the support in the region of the applied paste substance.

5. Process according to Claim 1,
**characterized in that**
the paste substance is applied to the support by means of screen print, tampon print, finger-writing technology and/or spray technology.

6. Process according to Claim 1,
**characterized in that**
the medium is applied within a time interval $\Delta t$ after application of the substance to the support, where the time interval $\Delta t$ is about 0.1 sec to about 600 sec, preferably about 1 sec to about 60 sec.

7. Process according to at least one of the preceding claims,
**characterized in that**
a paste with a circular cross section is applied to the support as substance, wherein the diameter d of the paste is in particular 50 $\mu$m $\leq$ d $\leq$ 300 $\mu$m, and preferably about 80 $\mu$m.

8. Process according to Claim 1,
**characterized in that**
water-soluble and water-insoluble solvents are added to the substance.

9. Process according to Claim 1,
**characterized in that**
the substance is applied in the form of dots or lines or strips to the support in such a way that the ratio a of heights to widths of the fully hardened substance is in particular 0.1 < a < 1.0, and in particular about 0.3.

10. Process according to Claim 1,
**characterized in that**
the support used is a silicon substrate with a surface layer consisting of silicon oxide and/or silicon nitride.

11. Process according to Claim 3,
**characterized in that**
the anionic surfactants used are soaps, fatty alcohol sulphates or alkylbenzenesulphonates.

12. Process according to Claim 3,
**characterized in that**
the cationic surfactants used are invert soaps.

13. Process according to Claim 3,
**characterized in that**
the non-ionic surfactants used are non-carboxylic esters of polyalcohols.

## Revendications

1. Procédé pour réaliser une structure sous forme de lignes et/ou de points sur un support, en particulier pour réaliser des contacts électriquement conducteurs sous forme de rayures sur un module semi-conducteur, tel qu'une cellule solaire, présentant les étapes suivantes:

   A) prévision d'une substance électriquement conductrice sous forme de pâte, à partir de laquelle les contacts électriquement conducteurs adhérant au support peuvent être formés par durcissement, la substance sous forme de pâte contenant un solvant polaire, et prévision d'un milieu contenant des molécules polaires, le milieu étant un liquide, une mousse ou un aérosol,
   B) application de la substance sous forme de pâte sur le support et application du milieu sur la substance sous forme de pâte de manière telle que le milieu peut agir sur la substance sous forme de pâte et que, pendant l'action, par interaction du milieu polaire avec le solvant polaire, qui se trouve à la surface de la substance en forme de pâte, du solvant polaire est extrait de la substance sous forme de pâte de telle sorte qu'un durcissement de la surface de la substance sous forme de pâte se produit,
   C) durcissement de la substance sous forme de pâte, les contacts électriquement conducteurs adhérant au support étant formés à partir de la substance.

2. Procédé selon la revendication 1, **caractérisé en ce que** des forces d'adhérence entre le milieu et le support sont supérieures à des forces d'adhérence entre la substance et le support.

3. Procédé selon au moins l'une quelconque des revendications précédentes, **caractérisé en ce qu'**on utilise, comme le milieu, un milieu tensioactif comprenant de l'eau et au moins un tensioactif du groupe formé par les tensioactifs anioniques, les tensioactifs cationiques, les tensioactifs amphotères, les tensioactifs non ioniques.

4. Procédé selon la revendication 3, **caractérisé en ce que** le milieu tensioactif est appliqué sur le support sous forme d'un liquide ou d'une mousse dans la zone de la substance appliquée sous forme de pâte.

5. Procédé selon la revendication 1, **caractérisé en ce que** la substance sous forme de pâte est appliquée sur le support par sérigraphie, par tampographie, par technique d'écriture au doigt et/ou par technique de pulvérisation.

6. Procédé selon la revendication 1, **caractérisé en ce que** le milieu est appliqué sur le support en un intervalle de temps Δt après l'application de la substance, l'intervalle de temps Δt valant environ 0,1 sec à environ 600 sec, de préférence environ 1 sec à environ 60 sec.

7. Procédé selon au moins l'une quelconque des revendications précédentes, **caractérisé en ce qu'**on applique sur le support, comme substance, une pâte présentant une section circulaire, la pâte présentant un diamètre d en particulier de 50 $\mu$m $\leq$ d $\leq$ 300 $\mu$m, et de préférence d'environ 80 $\mu$m.

8. Procédé selon la revendication 1, **caractérisé en ce que** des solvants solubles et insolubles dans l'eau sont ajoutés à la substance.

9. Procédé selon la revendication 1, **caractérisé en ce que** la substance est appliquée sous forme de points, de lignes ou de rayures sur le support de manière telle que la substance durcie présente un rapport a de hauteur à largeur en particulier de 0,1 < a < 1,0, en particulier a d'environ 0,3.

10. Procédé selon la revendication 1, **caractérisé en ce qu'**on utilise, comme support, un substrat de silicium présentant une couche de surface constituée par de l'oxyde de silicium et/ou du nitrure de silicium.

11. Procédé selon la revendication 3, **caractérisé en ce qu'**on utilise, comme tensioactifs anioniques, des savons, des sulfates d'alcool gras ou des alkylbenzènesulfonates.

12. Procédé selon la revendication 3, **caractérisé en ce qu'**on utilise, comme tensioactifs cationiques, des savons invertis.

13. Procédé selon la revendication 3, **caractérisé en ce qu'**on utilise, comme tensioactifs non ioniques, des esters non carboxyliques de polyalcools.

Fig. 1

Fig. 2

**23**        **18**

**22**

Fig. 3

**H**

**28**

**30**

**32**     **34**

**B**

Fig. 4

A    B    C    D

38   38   42 38 40  48 38 46

36          44      50

EP 1 723 681 B1

# Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4726850 A
- WO 9324934 A
- US 6312864 B
- US 6322620 B
- JP 63268773 A

**In der Beschreibung aufgeführte Nicht-Patentliteratur**

- Screen-Printed Rapid Thermal Processed (RTP) Selective Emitter Solar Cells Using a Single Diffusion Step. *16th European Photovoltaic Solar Energy Conference,* 01. Mai 2000, 1087-1090
- High Quality Screen-Printed and Fired-Through Silicon Nitride Rear Contacts For Bifacial Silicon Solar Cells. *16th Europeän Photovoltaic Solar Energy Conference,* 15. Mai 2000, 1332-1335